# EUROPEAN PATENT APPLICATION

(11) **EP 4 209 631 A1**
(43) Date of publication of application: **12.07.2023**
(21) Application number: 22203925.7
(22) Date of filing: 26.10.2022
(51) Int. Cl.: D06F 34/30, D06F 25/00, D06F 34/34

(54) **MOVABLE CONSOLE MECHANISM FOR HUMAN MACHINE INTERFACE**

(30) Priority: 28.12.2021 US 202117563528
(71) Applicant: Whirlpool Corporation, Benton Harbor, MI 49022 (US)
(72) Inventor: Rajendran, Arun, 21024 Cassinetta di Biandronno (VA) (IT)
(74) Representative: Spina, Alessandro

(57) **Abstract**

A household appliance (10) has a cabinet (12) containing working operable elements of the appliance (10). A control console (14) for the appliance (10) is associated with the cabinet (12). A user interface (20), supplying information to a user, is associated with the control console (14). The user interface (20) moves with respect to the control console (14) to a desired viewing angle for the user. The user interface (20) has a bezel (24) to hold the user interface (20). The bezel (24) is rotatable with respect to the control console (14). A rotary damper (28) is coupled with bezel (24) to control rotation of the bezel (24) and hold the user interface (20) in one or more viewing angles.

## Description

### FIELD

The present disclosure relates to household appliances and, more particularly, to washers, dryers, and combination washer/dryer machines with a movable human machine interface.

### BACKGROUND

Household appliances, such as washers, dryers, and combination washer/dryers, typically include a cabinet that receives operable elements as well as a console. The console includes various types of controls for operation of the particular appliance. Generally, the consoles include an interface that provides the user with information about the functioning of the appliance. Ordinarily, these interfaces are fixed to the console. The interface may be fixed at an angle with respect to the front surface of the console and therefore may be at an angle with respect to the front face of the appliance, which is typically perpendicular to the ground or slightly angled with respect to the ground. This fixing or positioning of the interface is designed and selected for viewing by a specific group of users. Thus, it does not provide optimal viewing for all percentages of users.

Generally, a tall user is required to bend or kneel down in order to see the particular interface. Handicap people in wheelchairs may not be able to view the particular interface. Thus, a substantial percentage of users may be unable to readily view the interface associated with the appliance console. Thus, it is desirable to provide a household appliance where the interfaces can be viewed by all users.

Accordingly, the present disclosure provides a human machine interface that is viewable by substantially all perspective users. The present disclosure provides an interface that is movable between positions to enable users of all heights to readily view and ascertain the information on the interface.

### SUMMARY

This section provides a general summary of the disclosure and is not a comprehensive disclosure of its full scope or all of its features.

Accordingly to a first aspect of the disclosure, a household appliance comprises a cabinet with operable elements of the appliance within the cabinet. A control console is associated with and generally positioned on a front panel or on a top of the appliance. A human machine interface for supplying information to the user is associated with the control console. The interface moves with respect to the control console to provide a desired viewing zone for a user. The interface further comprises a bezel for holding the interface. The bezel is rotatable with respect to the console. A rotary damper is coupled with bezel to control rotation of the bezel and hold the bezel in one or more viewing zones. The bezel includes a pivot hinge defining an axis. The hinge is coupled with the rotary damper to enable rotation. The bezel is pushed to rotate away from or into the console to a position providing one of the desired viewing zones. An additional push on the bezel retracts the bezel to its original position with respect to the console. A ribbon cable is coupled between the interface and the controls of the appliance. The interface is angled with respect to a surface of the console at an angle of from about 0° to 45°. Also, the interface is positioned at an angle of about 0° to 30° with respect to an axis or plane of the viewer, which is substantially horizontal. The viewing zones compensate for various heights of the users.

Accordingly to a second embodiment of the disclosure, a human machine interface for a household appliance comprises an interface supplying information to a user. The interface may be coupled with a control console. The interface moves with respect to the control console to provide a desired viewing zone for the user. The interface further comprises a bezel for holding the interface. The bezel is rotatable with respect to the console. A rotary damper is coupled with the bezel to control rotation of the bezel and hold the bezel in one or more viewing zones. The bezel includes a pivot hinge defining an axis. The hinge is coupled with the rotary damper to enable the rotation. The bezel is pushed to rotate away from or into the console to a position providing one of the desired viewing zones. An additional push on the bezel retracts the bezel to its original position with respect to the console. A ribbon cable is coupled between the interface and the controls of the appliance. The interface is angled with respect to a surface of the console at an angle of from about 0° to 45°. Also, the interface is positioned at an angle of about 0° to 30° with respect to an axis or plane of the viewer, which is substantially horizontal. The viewing zones compensate for various heights of the users.

According to a third aspect of the disclosure, a console for a household appliance comprises a housing defining a console. The housing includes a front face. An interface supplying information to a user may be coupled with a control console. The interface moves with respect to the control console to provide a desired viewing zone for the user. The interface further comprises a bezel for holding the interface. The bezel is rotatable with respect to the console. A rotary damper is coupled with the bezel to control rotation of the bezel and hold the bezel in one or more viewing zones. The bezel includes a pivot hinge defining an axis. The hinge is coupled with the rotary damper to enable the rotation. The bezel is pushed to rotate away from or into the console to a position providing one of the desired viewing zones. An additional push on the bezel retracts the bezel to its original position with respect to the console. A ribbon cable is coupled between the interface and the controls of the appliance. The interface is angled with respect to a surface of the console at an angle of from about 0° to 45°. Also, the interface is positioned at an angle of about 0° to 30° with respect to an axis or plane of the viewer, which is substantially horizontal. The viewing zones compensate for various heights of the users.

According to another aspect of the present disclosure, a household appliance is provided, comprising a cabinet and a user interface for supplying information to a user. The user interface is movable with respect to the cabinet with a bezel holding the user interface. The bezel is rotatable with respect to the cabinet and at least one rotary damper or linkage, coupled with the bezel, controls rotation of the bezel and holds the bezel and user interface in multiple viewing positions.

In accordance with another aspect of the present disclosure, the bezel includes hinge pins that couple the bezel with two rotary dampers.

In accordance with another aspect of the present disclosure, the user interface has a screen and the bezel may include two lateral legs and two longitudinal legs. One of the longitudinal legs of the bezel may include an opening to enable the screen to slide into the bezel. Alternatively, the bezel may have two lateral legs and one longitudinal leg to give the bezel a U-shape. In accordance with this aspect, the bezel may have a channel that is configured to receive the screen.

In accordance with another aspect of the present disclosure, the user interface pops out of the cabinet via an L-shaped linkage to provide a raised user interface. In accordance with this aspect, the user interface rotates via the linkage to a position where the user interface is in front of and substantially parallel to a front face of the cabinet. In accordance with a further aspect, the linkage slides along in a channel that enables the linkage to be raised and rotated which raises and rotates the user interface to the multiple viewing positions.

In accordance with another aspect of the present disclosure, the cabinet includes a top face and the user interface is flush-mounted with the top face of the cabinet in at least one of the multiple viewing positions. In accordance with this aspect of the present disclosure, the user interface is moveable with respect to the top face of the cabinet within a range of angles between 0 degrees and 100 degrees.

In accordance with another aspect of the present disclosure, the cabinet includes a front face and the user interface is flush-mounted with the front face of the cabinet in at least one of the multiple viewing positions. In accordance with this aspect of the present disclosure, the user interface is moveable with respect to the front face of the cabinet within a range of angles between negative 10 degrees and positive 90 degrees.

In accordance with another aspect of the present disclosure, the cabinet includes a control console on top of the cabinet and the user interface is flush-mounted with an outer face of the control console in at least one of the multiple viewing positions. In accordance with this aspect of the present disclosure, the user interface is moveable with respect to the outer face of the control console within a range of angles between 0 degrees and 45 degrees. In accordance with a further aspect, the rotatory dampers may be positioned in the control console.

Further areas of applicability will become apparent from the description provided herein. The description and specific examples in this summary are intended for purposes of illustration only and are not intended to limit the scope of the present disclosure.

### DRAWINGS

The drawings described herein are for illustrative purposes only of selected embodiments and not all possible implementations and are not intended to limit the scope of the present disclosure.

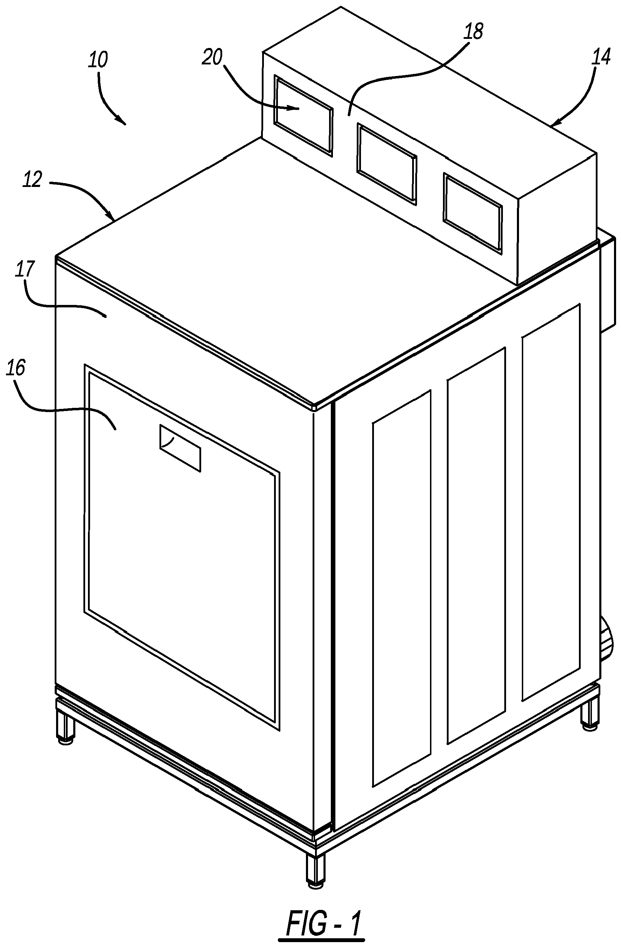

Fig. 1 is a perspective view of a household appliance with a control console in accordance with the present disclosure,
Fig. 2 is a perspective view of the control console illustrated in Fig. 1 with a user interface shown in multiple viewing positions,
Fig. 3 is a cross-section view of the control console illustrated in Fig. 1 with the user interface shown in multiple viewing positions
Fig. 4 is an exploded perspective view of the user interface illustrated in Fig. 2,
Fig. 5A is a perspective view of a second embodiment of a household appliance with a cabinet and a user interface provided on a front face of the cabinet,
Fig. 5B is an elevation schematic view of the user interface shown in Fig. 5A where the user interface is shown in a first position,
Fig. 5C is an elevation schematic view of the user interface shown in Fig. 5A where the user interface is shown in a second position,
Fig. 5D is a schematic elevation view of the user interface shown in Fig. 5A where the user interface is shown in a third position,
Fig. 6A is a perspective view of a third embodiment of a household appliance with a cabinet and a user interface provided on a top face of the cabinet,
Fig. 6B is an elevation schematic view of the user interface shown in Fig. 6A where the user interface is shown in a first position,
Fig. 6C is an elevation schematic view of the user interface shown in Fig. 6A where the user interface is shown in a second position,
Fig. 6D is a schematic elevation view of the user interface shown in Fig. 6A where the user interface is shown in a third position,
Fig. 7A is a perspective view of a second embodiment of an appliance,
Fig. 7B is an elevation schematic view of the user interface shown in Fig. 7A where the user interface is shown in a first position,
Fig. 7C is an elevation schematic view of the user interface shown in Fig. 7A where the user interface is shown in a second position,
Fig. 7D is a schematic elevation view of the user interface shown in Fig. 7A where the user interface is shown in a third position,
Fig. 8A is a schematic view of a linkage for the user interface where the linkage is shown in a first position,
Fig. 8B is a schematic view of the linkage for the user interface where the linkage is shown in a raised position like in Fig. 7B,
Fig. 8C is a schematic view of the linkage for the user interface where the linkage is shown in a raised and tilted position, and
Fig. 8D is a schematic view of the linkage for the user interface where the linkage is shown in a forward position like in Fig. 7D.

### DETAILED DESCRIPTION

Example embodiments will now be described more fully with reference to the accompanying drawings.

Turning to the figures, a household appliance is illustrated and designated with the reference numeral 10. The household appliance 10 includes a cabinet 12 with a control console 14. The cabinet 12 includes a door 16 enabling access inside the cabinet 12 to the working operable elements of the household appliance 10. The control console 14 is illustrated as being on top of the cabinet 12. However, the control console 14 could be on a front face 17 or top face 19 of the cabinet 12. The control console 14 may include one or more user interfaces 20. The user interfaces 20 are human machine interfaces and provide a user with information on the household appliance 10. For example, the user interface 20 may provide information relating to functioning, using or operation of the household appliance 10.

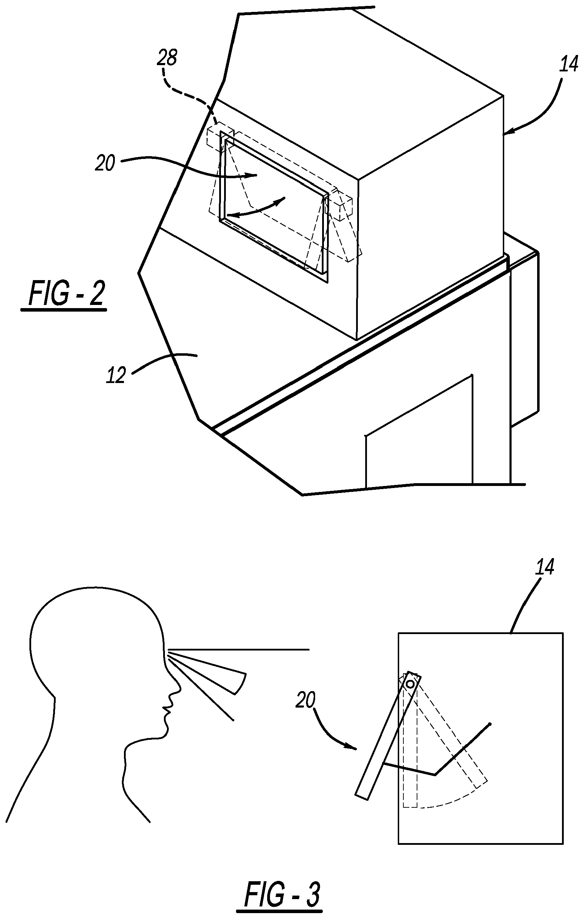

The user interface 20 is movable from a first position, substantially flush with the outer face 18 of the control console 14, to at least one second position angled with respect to the control console 14 as shown in Fig. 2. The angle with respect to the control console 14 from the outer face 18 may vary between 0 degrees and 45 degrees. Additionally, the user interface 20 is positioned at an angle of about 0 degrees and 30 degrees with respect to an axis or plane of the viewer, that is substantially horizontal. This provides for various viewing zones to compensate for various heights of users.

The user interface 20 includes a screen 22 and a bezel 24 for receiving the screen 22. The bezel 24 includes hinge pins 26 that couple the bezel 24 with at least one rotary damper 28. The bezel 24 generally has an overall rectangular design to receive the rectangular screen 22. However, any shape or design could be utilized for the disclosure. The bezel 24 includes lateral legs 30 as well as longitudinal legs 32. The upper longitudinal leg 32 that is positioned closest to the hinge pins 26 includes an opening 33 at the top to enable the screen 22 to slide into the bezel 24. Alternatively, the upper longitudinal leg 32 could be eliminated to provide a U-shape bezel 24 configured to receive the screen 22 within channel 34, which may be defined by the lateral legs 30 and the lower longitudinal leg 32.

The rotary dampers 28 are positioned in the control console 14. The rotary dampers 28 control the movement or pivoting rotation of the user interface 20. Thus, when a user presses on the user interface 20, the user interface 20 rotates relative to the control console 14 to a position providing one of the desired viewing zones. An additional push on the user interface 20 may retract the screen 22 and bezel 24 into the control console 14. Thus, this provides various viewing zones to compensate for different heights of users.

Preferably, the user interface 20, in its flush position with the control console 14, can easily be read by an individual that would be sitting in a wheelchair or the like. Thus, the user would not need to move in order to view the user interface 20. Additionally, when the user interface 20 is oriented upward, it can be viewed by taller individuals. Additionally, the rotary dampers 28 may enable the user interface 20 to move inward into the control console 14. This enables an angle pointing downward with respect to the outer face 18 of the console 14 so that, if the user interface 20 is part of a stacked combination appliance, a shorter user could readily ascertain the information on the user interface 20.

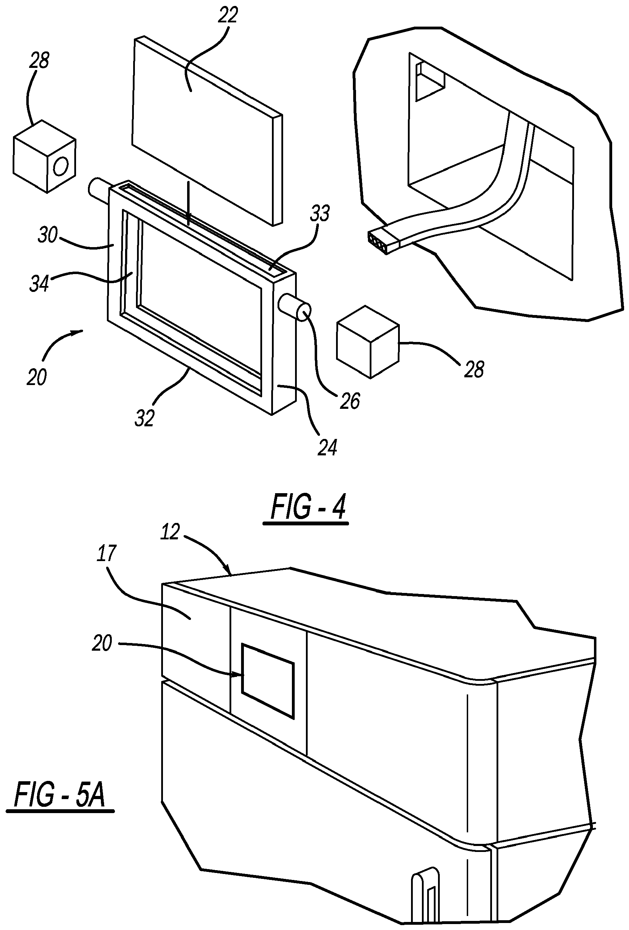

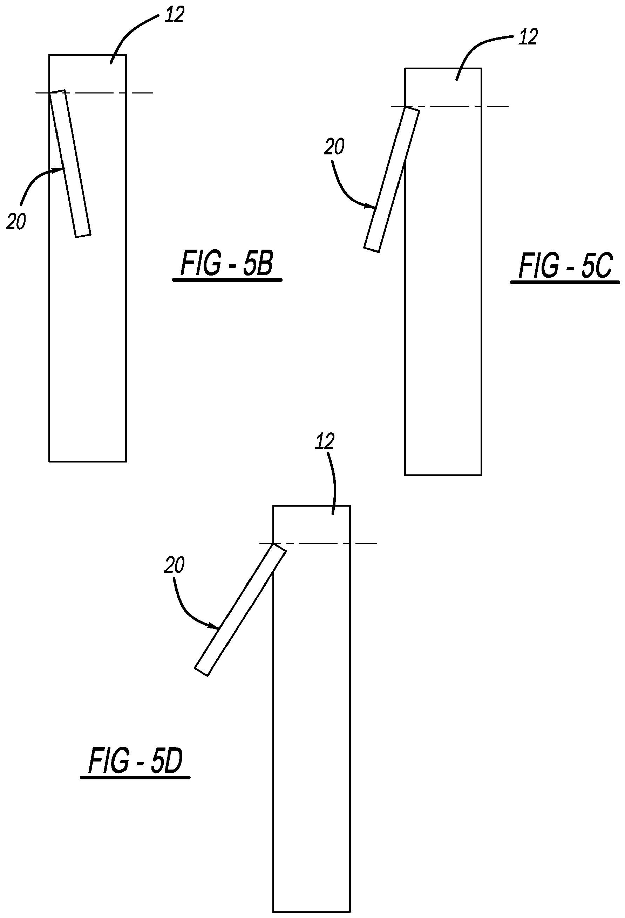

Fig. 5A illustrates the user interface 20 positioned on the front face 17 of the cabinet 12. Here, the user interface 20 is substantially flush with the front face 17 of the cabinet 12. The user interface 20 can be moved to a plurality of positions with respect to the cabinet 12 as illustrated in Figs. 5B-5D. The angle with respect to the front face 17 of the cabinet 12 may vary between -10 degrees to 90 degrees as the user interface 20 swings between positions. In Fig. 5B, the user interface 20 is illustrated in a negative degree position that enables accessibility for a shorter person. In Fig. 5C, the user interface 20 is illustrated in a positive degree position that enables access for a medium to taller person. In Fig. 5D, the user interface 20 is at a larger positive degree position that provides accessibility for a taller person. Thus, the user interface 20 can swing out of the cabinet 12 so that the user interface 20 is substantially parallel to the front face 17 of the cabinet 12.

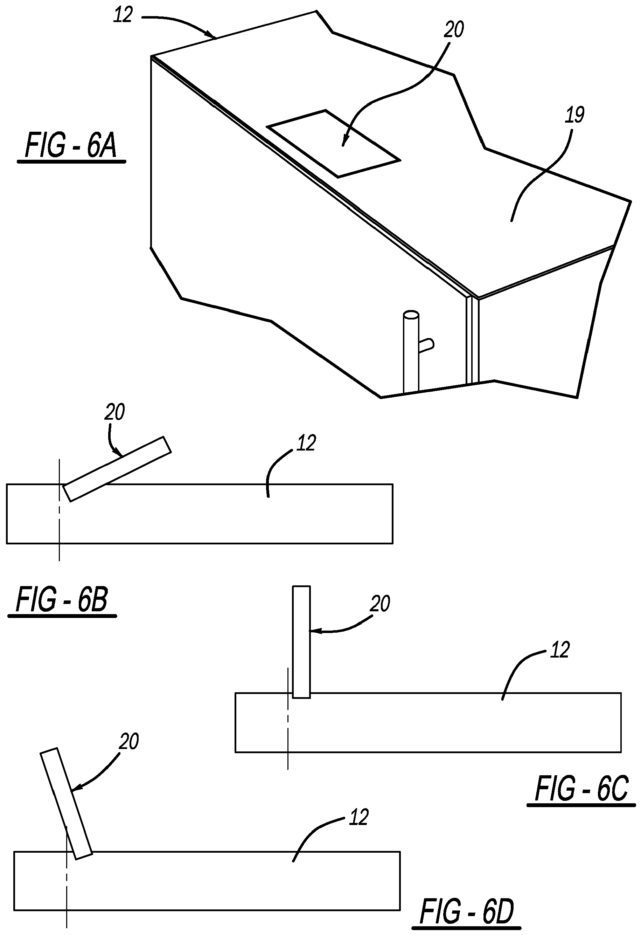

Moving to Fig. 6A, the user interface 20 is illustrated on the top face 19 of the cabinet 12. Here, the user interface 20 is substantially flush with the top face 19 of the cabinet 12 and can be moved to a number of positions. The angle with respect to the top face 19 of the cabinet 12 may vary between 0 degrees to 100 degrees. This is illustrated in Figs. 6B-6D. In Fig. 6B, the user interface 20 is illustrated at a small positive angle with respect to the top face 19 of the cabinet 12. Here, this allows accessibility for a taller person. In Fig. 6C, the user interface 20 is approximately perpendicular with the top face 19 of the cabinet 12. Here, this allows accessibility for a medium to taller person. Fig. 6D illustrates the user interface 20 angled at approximately 100 degrees faced downward toward horizontal to provide accessibility for a shorter person.

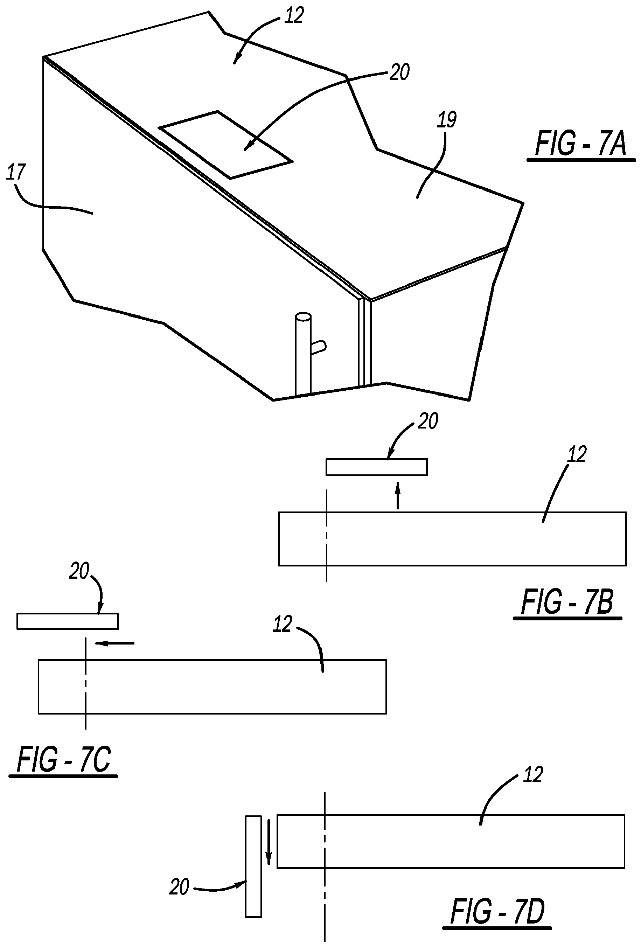

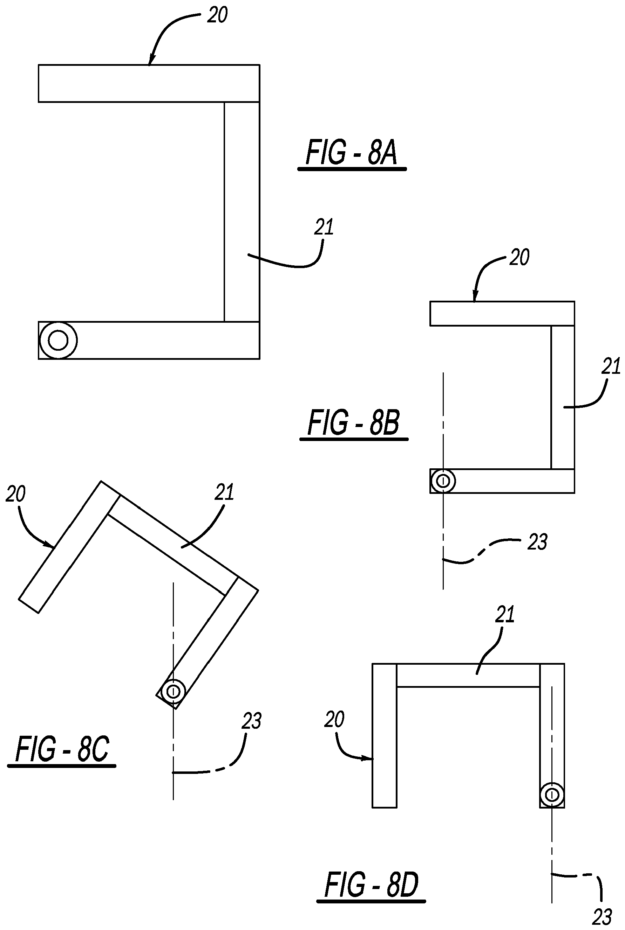

Figs. 7A-7D and Figs. 8A-8D illustrate an additional embodiment. The user interface 20 is positioned on the top face 19 of the cabinet 12 like that in Fig. 6A. However, the user interface 20 pops out of the cabinet 12, via a linkage 21, to provide a raised user interface 20 as illustrated in Fig. 7B. Here, the user interface 20 is rotated via the linkage 21 to a position where it is in front of and substantially parallel to the front face 17 of the cabinet 12. Thus, this provides an angle with respect to the top face 19 of the cabinet 12 from between 0 degrees to 270 degrees with respect to the top face 19 of the cabinet 12. As can be seen in Figs. 8A-8D, the linkage has an overall L-shape and slides along in a channel 23 that enables the linkage to be raised and rotated which, in turn, raises and rotates the user interface 20 to the positions illustrated in Figs. 7B-7D. Thus, depending upon the angle range, the user interface 20 is capable for accommodating taller and shorter people to enable accessibility.

The foregoing description of the embodiments has been provided for purposes of illustration and description. It is not intended to be exhaustive or to limit the disclosure. Individual elements or features of a particular embodiment are generally not limited to that particular embodiment, but, where applicable, are interchangeable and can be used in a selected embodiment, even if not specifically shown or described. The same may also be varied in many ways. Such variations are not to be regarded as a departure from the disclosure, and all such modifications are intended to be included within the scope of the disclosure.

## Claims

1. A household appliance (10), comprising:
a cabinet (12);
a user interface (20) for supplying information to a user, wherein the user interface (20) is movable with respect to the cabinet (12);
a bezel (24) holding the user interface (20), wherein the bezel (24) is rotatable with respect to the cabinet (12); and
at least one rotary damper (28) or linkage (21) coupled with the bezel (24) that controls rotation of the bezel (24) and holds the bezel (24) and the user interface (20) in multiple viewing positions.

2. The household appliance (10) of Claim 1, wherein the bezel (24) includes hinge pins (26) that couple the bezel (24) with two rotary dampers (28).

3. The household appliance (10) of Claims 1 or 2, wherein the bezel (24) includes two lateral legs (30) and two longitudinal legs (32).

4. The household appliance (10) of Claim 3, wherein the user interface (20) includes a screen (22) and wherein one of the longitudinal legs (32) of the bezel (24) includes an opening (33) to enable the screen (22) to slide into the bezel (24).

5. The household appliance (10) of Claims 1 or 2, wherein the user interface (20) includes a screen (22) and wherein the bezel (24) includes two lateral legs (30) and one longitudinal leg (32) to give the bezel (24) a U-shape and wherein the bezel (24) has a channel (34) that is configured to receive the screen (22).

6. The household appliance (10) of Claim 1, wherein the user interface (20) pops out of the cabinet (12) via an L-shaped linkage (21) to provide a raised user interface (20).

7. The household appliance (10) of Claim 6, wherein the user interface (20) rotates via the linkage (21) to a position where the user interface (20) is in front of and substantially parallel to a front face (17) of the cabinet (12).

8. The household appliance (10) of Claims 6 or 7, wherein the linkage (21) slides along in a channel (23) that enables the linkage (21) to be raised and rotated which raises and rotates the user interface (20) to the multiple viewing positions.

9. The household appliance (10) of any one of Claims 1-8, wherein the cabinet (12) includes a top face (19) and the user interface (20) is flush-mounted with the top face (19) of the cabinet (12) in at least one of the multiple viewing positions.

10. The household appliance (10) of Claim 9, wherein the user interface (20) is moveable with respect to the top face (19) of the cabinet (12) within a range of angles between 0 degrees and 100 degrees.

11. The household appliance (10) of any one of Claims 1-5, wherein the cabinet (12) includes a front face (17) and the user interface (20) is flush-mounted with the front face (17) of the cabinet (12) in at least one of the multiple viewing positions.

12. The household appliance (10) of Claim 11, wherein the user interface (20) is moveable with respect to the front face (17) of the cabinet (12) within a range of angles between negative 10 degrees and positive 90 degrees.

13. The household appliance (10) of any one of Claims 1-5, wherein the cabinet (12) includes a control console (14) on top of the cabinet (12) and the user interface (20) is flush-mounted with an outer face (18) of the control console (14) in at least one of the multiple viewing positions.

14. The household appliance of Claim 13, wherein the user interface (20) is moveable with respect to the outer face (18) of the control console (14) within a range of angles between 0 degrees and 45 degrees.

15. The household appliance (10) of Claim 2, wherein the cabinet (12) includes a control console (14) on top of the cabinet (12) and the rotatory dampers (28) are positioned in the control console (14).
